# EUROPEAN PATENT APPLICATION

(11) **EP 4 685 497 A1**
(43) Date of publication of application: **28.01.2026**
(21) Application number: 25186259.5
(22) Date of filing: 30.06.2025
(51) Int. Cl.: G01R 15/18, G01R 15/20

(54) **CURRENT SENSOR HAVING A STRUCTURE CONFIGURED TO IMPROVE CURING**

(30) Priority: 26.07.2024 CN 202411012535
(71) Applicant: Honeywell International Inc., Charlotte, NC 28202 (US)
(72) Inventor: YANG, Fan, Charlotte, 28202 (US); AI, Lei, Charlotte, 28202 (US); HU, Yu, Charlotte, 28202 (US); CHEN, Wu, Charlotte, 28202 (US); XU, Jiacheng, Charlotte, 28202 (US); LIANG, Feng, Charlotte, 28202 (US)
(74) Representative: Haseltine Lake Kempner LLP

(57) **Abstract**

A current sensing system may include a housing having a chamber configured to contain an epoxy, the housing further comprising a magnetic core having a gap configured to surround the chamber and a spacer structure mechanically coupled to the magnetic core configured to stabilize the gap of the magnetic core. The current sensing system may further include a Hall sensing element comprised within the chamber and surrounded by the epoxy. The spacer structure may be further configured to allow the epoxy to sufficiently cure at temperatures at or above a predetermined threshold.

## Description

### FIELD OF THE INVENTION

Embodiments of the present disclosure generally relate to current sensors having structures configured to improve curing.

### BACKGROUND

Current sensors, for example, such as Hall current sensors are configured to measure current in various environments using Hall sensing elements. In some examples, Hall current sensors include a material configured to protect the Hall sensing elements from contaminants. However, in some examples, the protective material may not sufficiently cure. Applicant has identified many technical challenges and difficulties associated with such current sensors. Through applied effort, ingenuity, and innovation, many of these identified problems have been solved by developing solutions that are included in embodiments of the present disclosure, many examples of which are described in detail herein.

### BRIEF SUMMARY

Various example embodiments described herein relate to vacuum pressure sensors and methods for fabrication thereof.

In accordance with various embodiments of the present disclosure, a system is provided. In some embodiments, the system comprises a housing having a chamber configured to contain an epoxy, the housing further comprising: a magnetic core having a gap configured to surround the chamber; and a spacer structure mechanically coupled to the magnetic core configured to stabilize the gap of the magnetic core; and a Hall sensing element comprised within the chamber and surrounded by the epoxy.

In some embodiments, the housing is comprised of plastic, and the housing comprises a first housing component and a second housing component.

In some embodiments, the magnetic core is configured in a C-shape.

In some embodiments, the spacer structure comprises at least one protruding feature configured to protect the epoxy from contaminants on the magnetic core, and the spacer structure is comprised of metal.

In some embodiments, the at least one protruding feature extends at least a portion of a height of the housing.

In some embodiments, the epoxy is configured to surround the Hall sensing element, and the epoxy is configured to protect the Hall sensing element from contaminants and temperatures up to, at, or above 125 degrees Celsius.

In some embodiments, the epoxy is configured to cure at or above 125 degrees Celsius.

In accordance with various embodiments of the present disclosure, an apparatus is provided. In some embodiments, the apparatus comprises a housing having a chamber configured to contain an epoxy; a magnetic core having a gap configured to surround the chamber; and a spacer structure mechanically coupled to the magnetic core configured to stabilize the gap of the magnetic core.

In some embodiments, the housing is comprised of plastic and the housing comprises a first housing component and a second housing component.

In some embodiments, the magnetic core is configured in a C-shape.

In some embodiments, the spacer structure comprises at least one protruding feature configured to protect the epoxy from contaminants on the magnetic core, and the spacer structure is comprised of metal.

In some embodiments, the at least one protruding feature extends at least a portion of a height of the housing.

In some embodiments, the epoxy is configured to surround a Hall sensing element, and the epoxy is configured to protect the Hall sensing element from contaminants and temperatures up to, at, or above 125 degrees Celsius.

In some embodiments, the epoxy is configured to cure at or above 125 degrees Celsius.

In accordance with various embodiments of the present disclosure, a method is provided. In some embodiments, the method comprises: configuring a housing with a chamber for containing an epoxy, wherein the housing comprises a first housing component and a second housing component; disposing, within the housing, a magnetic core having a gap configured to surround the chamber; and mechanically coupling a spacer structure to the magnetic core, wherein the spacer structure is configured to stabilize the gap of the magnetic core.

In some embodiments, the method further comprises: coupling a circuit board comprising at least one Hall sensing element to the housing such that the circuit board is proximate to the magnetic core; and coupling a coil winding to the housing such that the coil winding is proximate to the circuit board and to the second housing component.

In some embodiments, the magnetic core is configured in a C-shape.

In some embodiments, the spacer structure comprises at least one protruding feature configured to protect the epoxy from contaminants on the magnetic core, and the spacer structure is comprised of metal.

In some embodiments, the at least one protruding feature extends at least a portion of a height of the housing.

In some embodiments, the epoxy is configured to surround a Hall sensing element, wherein the epoxy is configured to protect the Hall sensing element from contaminants and temperatures up to or above 125 degrees Celsius, and wherein the epoxy is configured to cure at or above 125 degrees Celsius.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 is a perspective view of an exemplary current sensor;
FIG. 2 is a perspective view of a housing of an exemplary current sensor;
FIG. 3A is a perspective view of an exemplary magnetic core;
FIG. 3B is a perspective view of an exemplary magnetic core and an exemplary spacer structure;
FIG. 4A is a perspective view of an exemplary spacer structure;
FIG. 4B is a bottom-up view of an exemplary spacer structure;
FIG. 5 is a cross-sectional view of an exemplary current sensor;
FIG. 6 is a series of perspective views of components of an exemplary current sensor; and
FIG. 7 is a flowchart of an exemplary method for fabricating a current sensor, in accordance with some embodiments of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," "bottom," "left," "right," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," "in some embodiments," and the like generally mean that the particular feature, structure, or characteristic following the phrase may be included in at least one embodiment of the present disclosure and may be included in more than one embodiment of the present disclosure (importantly, such phrases do not necessarily refer to the same embodiment).

The phrases "in one example," "according to one example," "in some examples," and the like generally mean that the particular feature, structure, or characteristic following the phrase may be included in at least one example of the present disclosure and may be included in more than one example of the present disclosure (importantly, such phrases do not necessarily refer to the same example).

If the specification states a component or feature "may," "can," "could," "should," "would," "preferably," "possibly," "typically," "optionally," "for example," "as an example," "in some examples," "often," or "might" (or other such language) be included or have a characteristic, that specific component or feature is not required to be included or to have the characteristic. Such component or feature may be optionally included in some examples, or it may be excluded.

The word "example" or "exemplary" is used herein to mean "serving as an example, instance, or illustration." Any implementation described herein as "example" or "exemplary" is not necessarily to be construed as preferred or advantageous over other implementations.

The term "electrically coupled," "electrically coupling," "electrically couple," "electrically connected," "electrically connecting," "electrically connect," "in communication with," or "in electronic communication with" in the present disclosure refers to two or more elements or components being connected through wired means and/or wireless means, such that signals, electrical voltage/current, data and/or information may be transmitted to and/or received from these elements or components.

The term "in fluid communication with" in the present disclosure refers to two or more elements or components being connected through one or more paths or pathways, such that a fluid or other flowing media may be input to and/or output from these elements or components.

The term "component" may refer to an article, a device, or an apparatus that may comprise one or more surfaces, portions, layers and/or elements. For example, an example component may comprise one or more substrates that may provide underlying layer(s) for the component and may comprise one or more elements that may form part of and/or are disposed on top of the substrate. In the present disclosure, the term "element" may refer to an article, a device, or an apparatus that may provide one or more functionalities.

The term "sensor" refers to a component that may detect, measure, and/or identify any one or more attributes or characteristics of an environment or media, including but not limited to current(s).

In some examples, current sensors relying on Hall sensing elements are configured to measure current by measuring magnetic field strength and converting the magnetic field strength into electrical output. For example, such current sensors may include magnetic cores configured to amplify the magnetic field strength. The current sensors may further include the Hall sensing elements in one or more gaps in the magnetic cores, as suitable for various applications.

In some examples, the position of the Hall sensing element is relied upon during measurement. Hall sensing elements are, in some examples, vulnerable to humidity, stress, pressure, and/or the like. Protective materials such as epoxy may be used to surround Hall sensing elements and protect them from various contaminants (e.g., moisture, air, etc.) and/or environmental effects (e.g., stress, pressure, etc.). For example, the accuracy of measurements performed by Hall sensing elements can be affected by the various contaminants and/or environmental effects. However, using a protective material to surround the Hall sensing element may introduce additional issues, for example, such as the possibility of insufficient curing of the protective material which would result in insufficient protection of the Hall sensing element. In some examples, high curing temperatures (e.g., at or above approximately 125 degrees Celsius) may damage electrical components of the Hall sensing element. In other examples, low curing temperatures may not allow the material to fully cure, resulting in insufficient protection of the Hall sensing element. In some examples, bubbles and/or air in the protective material may result in insufficient curing of the protective material. Contaminants such as oil and/or dust present on the magnetic core may further prevent the material from fully curing.

Embodiments of the present disclosure, in some examples, provide a current sensor having a structure configured to improve curing of a material (e.g., epoxy) surrounding a Hall sensing element. The current sensor may comprise a housing (e.g., a plastic housing) configured with one or more cavities including (i) a first cavity configured to contain a magnetic core, (ii) a second cavity disposed in the gap defined by the geometry of the magnetic core, and/or other cavities. The current sensor may include a magnetic core, which may take on a C shape, a substantially C shape, be curved through at least a portion of its structure, and/or the like, disposed within the first cavity of the housing. The magnetic core may be mechanically coupled to a spacer structure configured to stabilize (e.g., maintain) the gap of the magnetic core, as the Hall sensing element is sensitive the size of the gap. The spacer structure may be further configured to prevent oil, dust, and/or the like present on the magnetic core from contaminating the epoxy. The combined structure comprising the housing, the magnetic core, and the spacer structure may allow for sufficient curing (e.g., full curing) of the epoxy at high temperatures (e.g., at or above 125 degrees Celsius) while protecting the Hall sensing element from the heat.

As described herein, embodiments of the present disclosure, in some examples, provide methods for fabrication of current sensors having structures configured to improve curing.

To address challenges and limitations associated with current sensors and methods for fabrication thereof, various examples of the present disclosure may be provided. For example, various examples of the present disclosure may provide example systems, devices, and/or methods for current sensors having structures configured to improve curing and/or fabrication thereof.

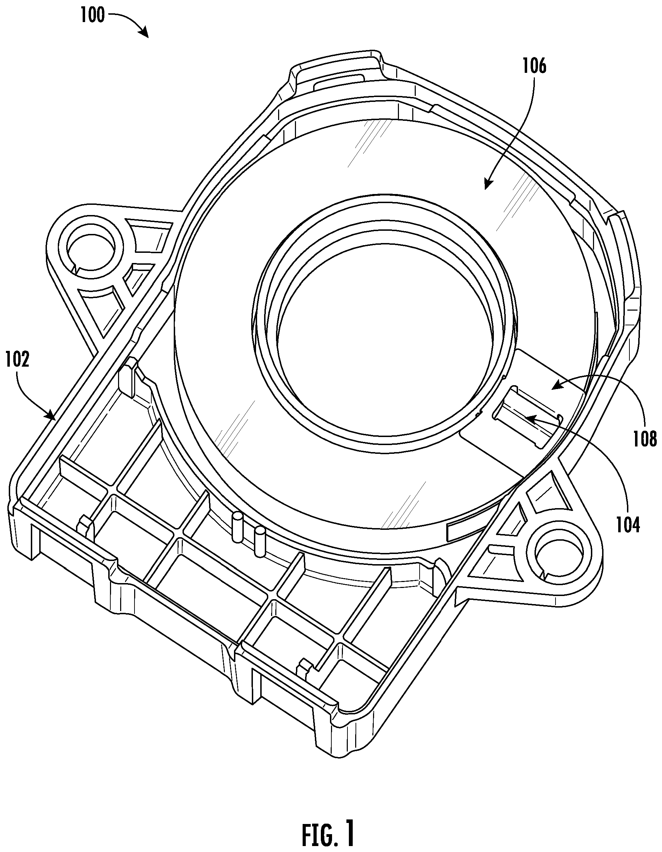

Referring now to FIG. 1, a perspective view of an exemplary current sensor 100 is provided. The current sensor 100 may be a Hall current sensor including a Hall sensing element configured to measure a magnetic field strength and convert that measurement into an electrical output representing a measurement of current. The current sensor 100 may comprise a housing 102, a chamber 104, a magnetic core 106, and a spacer structure 108. Although the example of FIG. 1 shows one housing, one chamber, one magnetic core, and one spacer structure, any number of such components may be present in a current sensor.

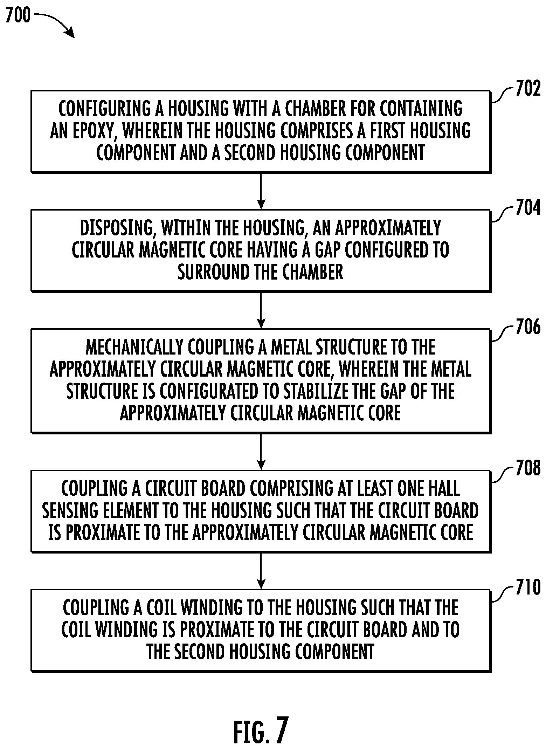

The housing 102 may be comprised of plastic and/or other materials. In some examples, the housing 102 may comprise a plurality of housing components, for example, such as a first housing component (e.g., a "bottom" housing component) and a second housing component (e.g., a "top" housing component). In the example of FIG. 1, only the first housing component - the so-called the "bottom" housing component - is shown, although both the first housing component and the second housing component may be present in a housing of a current sensor. An example method of fabricating and/or assembling a current sensor is further described herein with respect to FIG. 7.

The chamber 104 may be defined by the housing 102. For example, the housing 102 may define one or more cavities. The one or more cavities defined by the housing 102 may comprise a first cavity configured to contain the magnetic core 106 and/or a second cavity disposed in the gap defined by the geometry of the magnetic core 106 (further described herein). The chamber 104 may be the second cavity defined by the housing 102. The chamber 104 may be configured to contain at least a portion of the Hall sensing element and/or a material (e.g., an epoxy) surrounding at least a portion of the Hall sensing element. The material surrounding at least a portion of the Hall sensing element may fill at least a portion of the chamber 104.

The magnetic core 106 may be comprised of metal and/or other materials. The magnetic core 106 may take on a C shape, a substantially C shape, be curved through at least a portion of its structure, and/or the like,. For example, the magnetic core 106 may be substantially circular and may comprise a gap spanning at least a portion of the perimeter of the magnetic core 106. The size of the gap may tunable as suitable for various applications. In some examples, the Hall sensing element is disposed within the gap of the magnetic core 106. The magnetic core 106 may be mechanically coupled to the housing 102 via the first cavity defined by the housing 102. For example, the magnetic core 106 may snap into the first cavity defined by the housing 102.

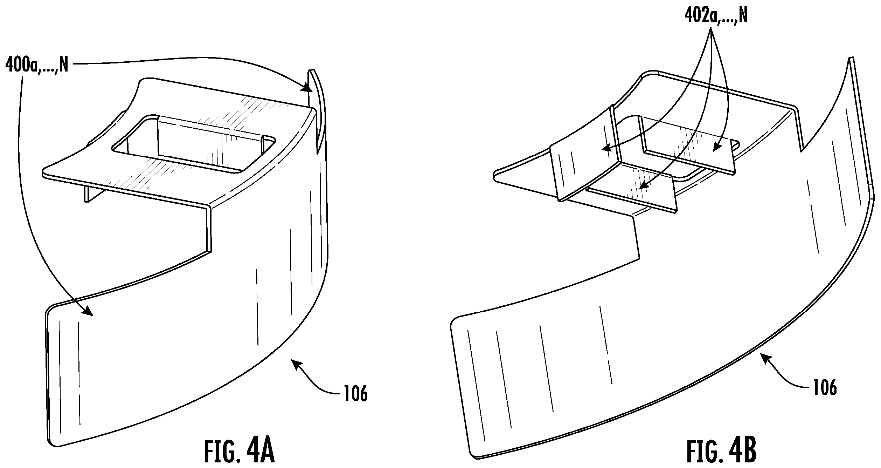

The spacer structure 108 may be comprised of metal and/or other materials. In some examples, the spacer structure 108 is comprised of a stiff material such that it does not easily deform in response to applied force and/or pressure. The spacer structure 108 may be mechanically coupled to the magnetic core 106. For example, the spacer structure 108 may snap into the gap defined by the geometry of the magnetic core 106. In some examples, the spacer structure 108 comprises one or more protruding features (further described herein with respect to FIG. 4B) configured to protect the material surrounding the Hall sensing element from contaminants. The spacer structure 108 may be further configured to stabilize the magnetic core 106 (e.g., cause the gap defined by the geometry of the magnetic core 106 to retain its size and/or shape), as the Hall sensing element may be sensitive to variations in the gap. In some examples, the spacer structure 108 is further configured to prevent air and/or bubbles from forming within the material surrounding the Hall sensing element.

The current sensor 100 may have a structure configured to improve curing of a material (e.g., epoxy) surrounding a Hall sensing element and filling at least a portion of a chamber containing the Hall sensing element. The current sensor 100 may comprise a housing (e.g., the housing 102) configured with one or more cavities including (i) a first cavity configured to contain a magnetic core (e.g., the magnetic core 106), (ii) a second cavity disposed in the gap defined by the geometry of the magnetic core (e.g., the chamber 104), and/or other cavities. The current sensor 100 may include a substantially circular magnetic core comprising a gap, wherein the substantially circular magnetic core is disposed within the first cavity of the housing. The substantially circular magnetic core may be mechanically coupled to a spacer structure (e.g., the spacer structure 108) configured to stabilize (e.g., maintain) the gap of the substantially circular magnetic core. The spacer structure may be further configured to prevent oil, dust, and/or the like present on the magnetic core from contaminating the material surrounding the Hall sensing element. The combined structure comprising the housing, the substantially circular magnetic core, and the spacer structure may allow for sufficient curing (e.g., full curing) of the material surrounding the Hall sensing element and filling at least a portion of the second cavity at high temperatures (e.g., at or above approximately 125 degrees Celsius) while protecting the Hall sensing element from the heat.

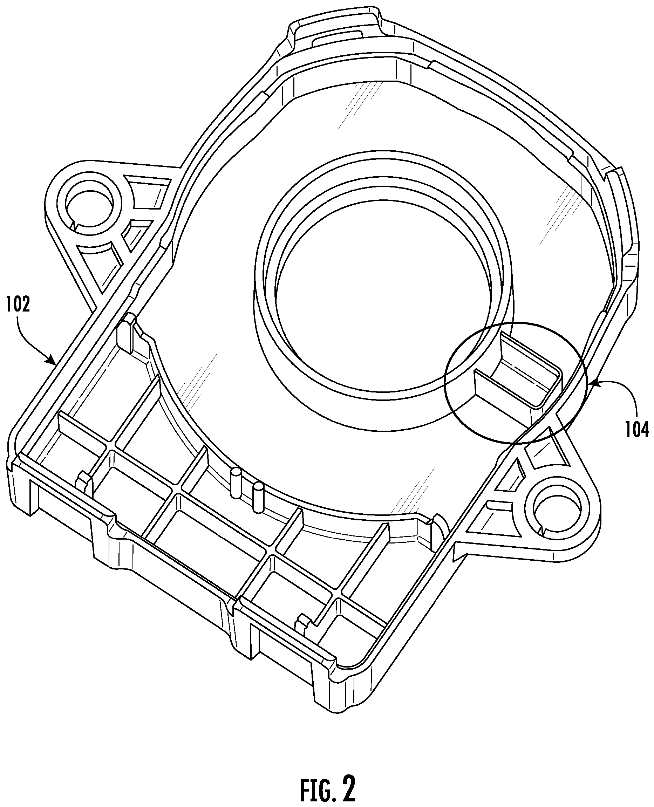

Referring now to FIG. 2, a perspective view of the housing 102 of the exemplary current sensor 100 is provided. In some examples, the housing 102 may comprise a plurality of housing components, for example, such as a first housing component (e.g., a "bottom" housing component) and a second housing component (e.g., a "top" housing component). In the example of FIG. 2, only the first housing component - the so-called the "bottom" housing component - is shown, although both the first housing component and the second housing component may be present in a housing of a current sensor.

The example of FIG. 2 shows the chamber 104. The chamber 104 may be defined by one or more walls (e.g., surfaces, planes, etc.) of the housing 102. In some examples, the chamber is rectangular, square, elliptical, and/or of any other shape, as suitable for various applications. In some examples, the chamber 104 is configured to contain at least a portion of the Hall sensing element and/or the material surrounding at least a portion of the Hall sensing element.

The first cavity defined by the housing 102 may comprise the rest of the perimeter of the magnetic core 106 (e.g., excluding the portion of the perimeter of the magnetic core 106 which defines the gap). In some examples, the first cavity defined by the housing is configured to contain the magnetic core 106.

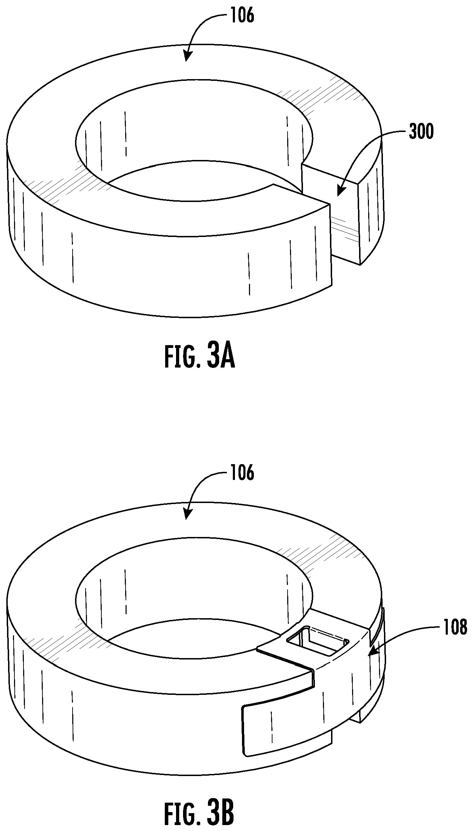

FIGS. 3A-3B show various views of the magnetic core 106. Referring now to FIG. 3A, a perspective view of an exemplary magnetic core is provided. The magnetic core 106 may be "C-shaped" such that it is substantially circular while comprising a gap 300 corresponding to a portion of the perimeter of the magnetic core 106. The gap 300 may be tunable as suitable for various applications. For example, the Hall sensing element may be sensitive to the size (e.g., width, length, height, etc.) of the gap 300.

Referring now to FIG. 3B, a perspective view of an exemplary magnetic core and an exemplary spacer structure is provided. The magnetic core 106 may be coupled to the spacer structure 108. For example, the magnetic core 106 may be mechanically coupled to the spacer structure 108 such that they snap together (e.g., such that at least one portion of the spacer structure 108 fits into the gap 300 of the magnetic core 106).

FIGS. 4A-4B show various views of the spacer structure 108. Referring now to FIG. 4A, a perspective view of an exemplary spacer structure is provided. The spacer structure 108 may comprise at least one side feature 400a,...,N (collectively "400"). The at least one side feature 400 may be configured to stabilize the magnetic core 106. For example, the at least one side feature may be configured to maintain the dimensions of the gap 300.

Referring now to FIG. 4B, a bottom-up view of an exemplary spacer structure is provided. The spacer structure 108 may comprise at least one bent feature 402a,...,N (collectively "402"). The at least one bent feature 402 may be configured to prevent contaminants (e.g., oils, dust, etc.) from contaminating the material surrounding at least a portion of the Hall sensing element and filling at least a portion of the chamber 104. The at least one bent feature 402 may be further configured to extend only a portion of the height of the magnetic core such that it does not interfere with operation of the current sensor.

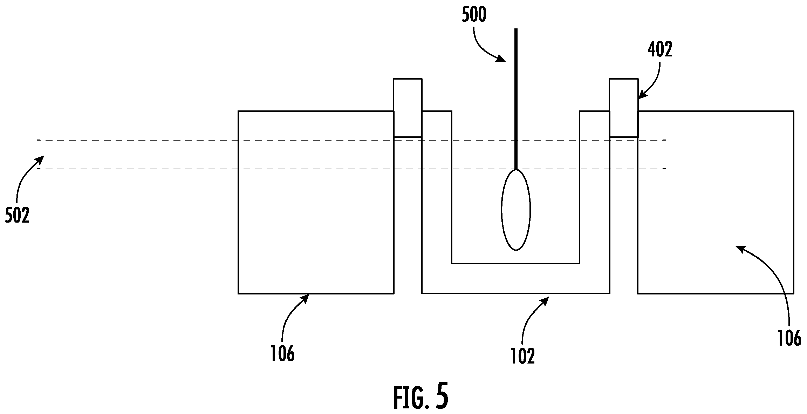

Referring now to FIG. 5, a cross-sectional view of an exemplary current sensor is provided. The exemplary current sensor may be the current sensor 100. The current sensor 100 may comprise the housing 102 defining the chamber 104, the magnetic core 108, the at least one bent feature 402 of the spacer structure 108, a Hall sensing element 500, and a gap 502. In some examples, the gap 502 is configured such that the at least one bent feature 402 extends only a portion of the height of the magnetic core such that it does not interfere with operation of the current sensor 100. For example, the at least one bent feature 402 and the Hall sensing element 500 may be configured such that the gap 502 separates the at least one bent feature 402 and the Hall sensing element 500.

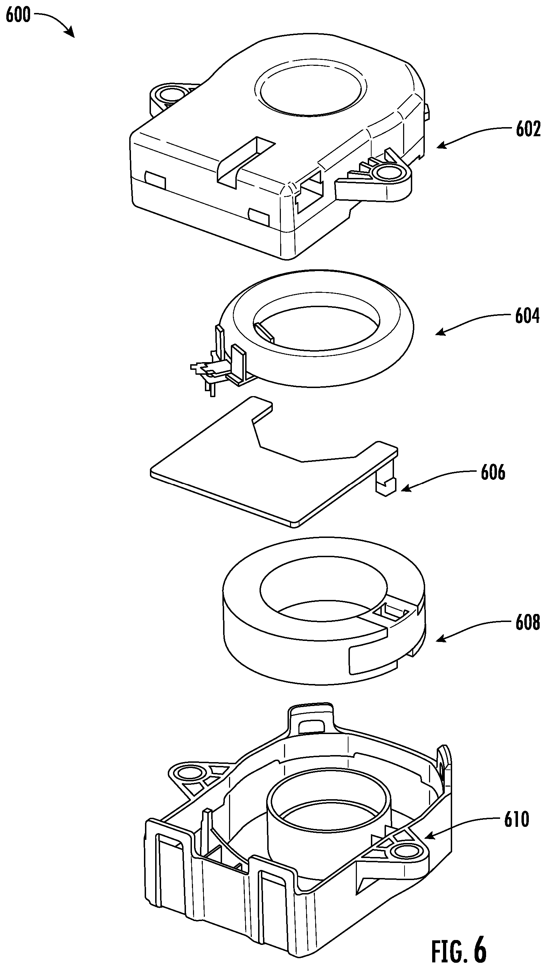

Referring now to FIG. 6, a series of perspective views 600 of components of an exemplary current sensor are provided. The series of perspective views 600 shows an exploded view of an exemplary current sensor (e.g., the current sensor 100). The series of perspective views 600 includes views 602, 604, 606, 608, and 610.

The view 602 shows a portion of the housing 102. The portion of the housing 102 shown in the view 602 may be the second housing component (the "top" housing component). The second housing component may be comprised of plastic and/or other materials. In some examples, the second housing component may be configured to cover and/or contain one or more components of the current sensor 100.

The view 604 shows a coil winding. In some examples, the current sensor 100 may omit the coil winding. In other examples, the coil winding is included in the current sensor 100. The coil winding may be configured to.... The coil winding may be disposed between the second housing component and a circuit board.

The view 606 shows a circuit board. The circuit board may comprise at least one Hall sensing element. The at least one Hall sensing element may be disposed such that it can be positioned within the gap 300 of the magnetic core 106 and/or within the chamber 104. The circuit board may further comprise other electrical components, such as application specific integrated circuits (ASICs), controller elements, and/or the like. The circuit board may be disposed between the coil winding and the magnetic core 106.

The view 608 shows the magnetic core 106 and the spacer structure 108. The magnetic core 106 and the spacer structure 108 may be mechanically coupled such that the at least one bent feature 402 of the spacer structure 108 snaps into the gap 300 of the magnetic core 106. The spacer structure 108 may be configured to stabilize the gap 300, allowing for consistent operation of the current sensor. The magnetic core 106 and the spacer structure 108 may be disposed between the circuit board and the first housing component.

The view 610 shows a portion of the housing 102. The portion of the housing 102 shown in the view 610 may be the first housing component (the "bottom" housing component). The first housing component may define one or more cavities for containing one or more components. For example, the first housing component may define a cavity configured to contain the magnetic core 106 and the spacer structure 108. For example, the first housing component may define a cavity configured to contain the material at least partially surrounding the Hall sensing element. In some examples, the cavity configured to contain the material is the chamber 104.

The components of the views 602-610 may be coupled to one another. For example, the magnetic core 106 and spacer structure 108 may mechanically couple with (e.g., snap into) a cavity defined by the first housing component. The circuit board may be disposed proximate to the magnetic core 106. For example, the portion of the circuit board comprising the Hall sensing element may snap into the gap 300 and/or the chamber 104. The coil winding may be electrically coupled to the circuit board. The second housing component may mechanically couple with the first housing component via at least one snap feature comprised by the second housing component and/or the first housing component.

Referring now to FIG. 7, a flowchart of an exemplary method 700 for fabricating a current sensor is provided. The current sensor may be the current sensor 100.

At step/operation 702, a housing (e.g., the housing 102) may be configured with a chamber (e.g., the chamber 104) for containing an epoxy. The housing may comprise a first housing component (e.g., the "bottom" housing component) and/or a second housing component (e.g., the "top" housing component).

At step/operation 704, an approximately circular magnetic core (e.g., the magnetic core 106) having a gap (e.g., the gap 300) configured to surround the chamber may be disposed within the housing.

At step/operation 706, a spacer structure (e.g., the spacer structure 108) may be coupled to the approximately circular magnetic core. The spacer structure may be comprised of metal. The spacer structure may be configured to stabilize the gap of the approximately circular magnetic core.

At step/operation 708, a circuit board comprising at least one Hall sensing element may be coupled to the housing such that the circuit board is proximate to the approximately circular magnetic core.

At step/operation 710, a coil winding may be coupled to the housing such that the coil winding is proximate to the circuit board and to the second housing component.

Operations and processes described herein support combinations of means for performing the specified functions and combinations of operations for performing the specified functions. It will be understood that one or more operations, and combinations of operations, may be implemented by special purpose hardware-based computer systems which perform the specified functions, or combinations of special purpose hardware and computer instructions.

In some example embodiments, certain ones of the operations herein may be modified or further amplified as described below. Moreover, in some embodiments additional optional operations may also be included. It should be appreciated that each of the modifications, optional additions or amplifications described herein may be included with the operations herein either alone or in combination with any others among the features described herein.

The foregoing method and process descriptions are provided merely as illustrative examples and are not intended to require or imply that the steps of the various embodiments must be performed in the order presented. As will be appreciated by one of skill in the art the order of steps in the foregoing embodiments may be performed in any order. Words such as "thereafter," "then," "next," and similar words are not intended to limit the order of the steps; these words are simply used to guide the reader through the description of the methods. Further, any reference to claim elements in the singular, for example, using the articles "a," "an" or "the," is not to be construed as limiting the element to the singular and may, in some instances, be construed in the plural.

While various embodiments in accordance with the principles disclosed herein have been shown and described above, modifications thereof may be made by one skilled in the art without departing from the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above, but is defined by the claims which follow, that scope including all equivalents of the subject matter of the claims. Each and every claim is incorporated as further disclosure into the specification and the claims are embodiment(s) of the present disclosure. Furthermore, any advantages and features described above may relate to specific embodiments but shall not limit the application of such issued claims to processes and structures accomplishing any or all of the above advantages or having any or all of the above features.

In addition, the section headings used herein are provided for consistency with the suggestions under 37 C.F.R. § 1.77 or to otherwise provide organizational cues. These headings shall not limit or characterize the disclosure set out in any claims that may issue from this disclosure. For instance, a description of a technology in the "Background" is not to be construed as an admission that certain technology is prior art to any disclosure in this disclosure. Neither is the "Summary" to be considered as a limiting characterization of the disclosure set forth in issued claims. Furthermore, any reference in this disclosure to "disclosure" or "embodiment" in the singular should not be used to argue that there is only a single point of novelty in this disclosure. Multiple embodiments of the present disclosure may be set forth according to the limitations of the multiple claims issuing from this disclosure, and such claims accordingly define the disclosure, and their equivalents, which are protected thereby. In all instances, the scope of the claims shall be considered on their own merits in light of this disclosure but should not be constrained by the headings set forth herein.

Also, systems, subsystems, apparatuses, techniques, and methods described and illustrated in the various embodiments as discrete or separate may be combined or integrated with other systems, modules, techniques, or methods without departing from the scope of the present disclosure. Other devices or components shown or discussed as coupled to, or in communication with, each other may be indirectly coupled through some intermediate device or component, whether electrically, mechanically, or otherwise. Other examples of changes, substitutions, and alterations are ascertainable by one skilled in the art and could be made without departing from the scope disclosed herein.

Many modifications and other embodiments of the disclosure set forth herein will come to mind to one skilled in the art to which these embodiments pertain having the benefit of teachings presented in the foregoing descriptions and the associated figures. Although the figures only show certain components of the apparatuses and systems described herein, various other components may be used in conjunction with the components and structures disclosed herein. Therefore, it is to be understood that the disclosure is not to be limited to the specific embodiments disclosed and that modifications and other embodiments are intended to be included within the scope of the appended claims. For example, the various elements or components may be combined, rearranged, or integrated in another system or certain features may be omitted or not implemented. Moreover, the steps in any method described above may not necessarily occur in the order depicted in the accompanying drawings, and in some cases one or more of the steps depicted may occur substantially simultaneously, or additional steps may be involved. Although specific terms are employed herein, they are used in a generic and descriptive sense only and not for purposes of limitation.

## Claims

1. A system comprising:
a housing having a chamber configured to contain an epoxy, the housing further comprising:
a magnetic core having a gap configured to surround the chamber; and
a spacer structure mechanically coupled to the magnetic core configured to stabilize the gap of the magnetic core; and
a Hall sensing element comprised within the chamber and surrounded by the epoxy.

2. The system of claim 1, wherein the housing is comprised of plastic, and wherein the housing comprises a first housing component and a second housing component.

3. The system of any of claims 1 or 2, wherein the magnetic core is configured in a C-shape.

4. The system of any of claims 1 to 3, wherein the spacer structure comprises at least one protruding feature configured to protect the epoxy from contaminants on the magnetic core, and wherein the spacer structure is comprised of metal.

5. The system of any of claims 1 to 4, wherein the at least one protruding feature extends at least a portion of a height of the housing.

6. The system of any of claims 1 to 5, wherein the epoxy is configured to surround the Hall sensing element, and wherein the epoxy is configured to protect the Hall sensing element from contaminants and temperatures up to, at, or above 125 degrees Celsius.

7. The system of any of claims 1 to 6, wherein the epoxy is configured to cure at or above 125 degrees Celsius.

8. An apparatus comprising:
a housing having a chamber configured to contain an epoxy;
a magnetic core having a gap configured to surround the chamber; and
a spacer structure mechanically coupled to the magnetic core configured to stabilize the gap of the magnetic core.

9. The apparatus of claim 8, wherein the housing is comprised of plastic, and wherein the housing comprises a first housing component and a second housing component.

10. The apparatus of any of claims 8 or 9, wherein the magnetic core is configured in a C-shape.

11. The apparatus of any of claims 8 to 10, wherein the spacer structure comprises at least one protruding feature configured to protect the epoxy from contaminants on the magnetic core, and wherein the spacer structure is comprised of metal.

12. The apparatus of any of claims 8 to 11, wherein the at least one protruding feature extends at least a portion of a height of the housing.

13. The apparatus of any of claims 8 to 12, wherein the epoxy is configured to cure at or above 125 degrees Celsius, wherein the epoxy is configured to surround a Hall sensing element, and wherein the epoxy is configured to protect the Hall sensing element from contaminants and temperatures up to, at, or above 125 degrees Celsius.

14. A method comprising:
configuring a housing with a chamber for containing an epoxy, wherein the housing comprises a first housing component and a second housing component;
disposing, within the housing, a magnetic core having a gap configured to surround the chamber; and
mechanically coupling a spacer structure to the magnetic core, wherein the spacer structure is configured to stabilize the gap of the magnetic core.

15. The method of claim 14, further comprising:
coupling a circuit board comprising at least one Hall sensing element to the housing such that the circuit board is proximate to the magnetic core; and
coupling a coil winding to the housing such that the coil winding is proximate to the circuit board and to the second housing component.
